# EUROPEAN PATENT APPLICATION

(11) **EP 4 459 863 A1**
(43) Date of publication of application: **06.11.2024**
(21) Application number: 24173783.2
(22) Date of filing: 02.05.2024
(51) Int. Cl.: H02P 29/024, G01R 31/34, G05B 23/02

(54) **SYSTEM AND METHOD FOR TESTING ELECTRONIC DRIVING MEANS FOR AN ELECTRIC MOTOR**

(30) Priority: 02.05.2023 IT 202300008535
(71) Applicant: Brushless Technology S.r.l., 10143 Torino (IT)
(72) Inventor: NICOSIA, Angelo Alberto, I-10148 TORINO (IT)
(74) Representative: Cristinelli, Luca

(57) **Abstract**

A system (200) is described for testing electronic drive means for an electric motor, comprising:
- electronic control means (202) arranged to provide a test drive command to the electronic drive means (204);
- an electric test motor (205) arranged to be connected to the electronic drive means (204) to be tested and comprising a first rotor (206), the rotation of which is controlled by the electronic drive means (204) to be tested according to the test drive command received;
- electrical energy supply means (208) arranged to provide electrical power to the electric test motor (205) and to the electronic drive means (204);
- an electric dragged motor (210) comprising a second rotor (212);
- motion transmission means (214) arranged to transmit the rotation of the first rotor (206) of the test electric motor (205) to the second rotor (212) of the electric dragged motor (210);
- current sensor means (216) arranged to measure a current absorbed by the test electric motor (205) indicative of the operation of said electronic drive means (204) to be tested. A corresponding method is also described.

## Description

### Technical field

This invention is generally in the field of electric motors; in particular, the invention relates to a system for testing electronic drive means for an electric motor and a method for testing electronic drive means for an electric motor.

### Prior art

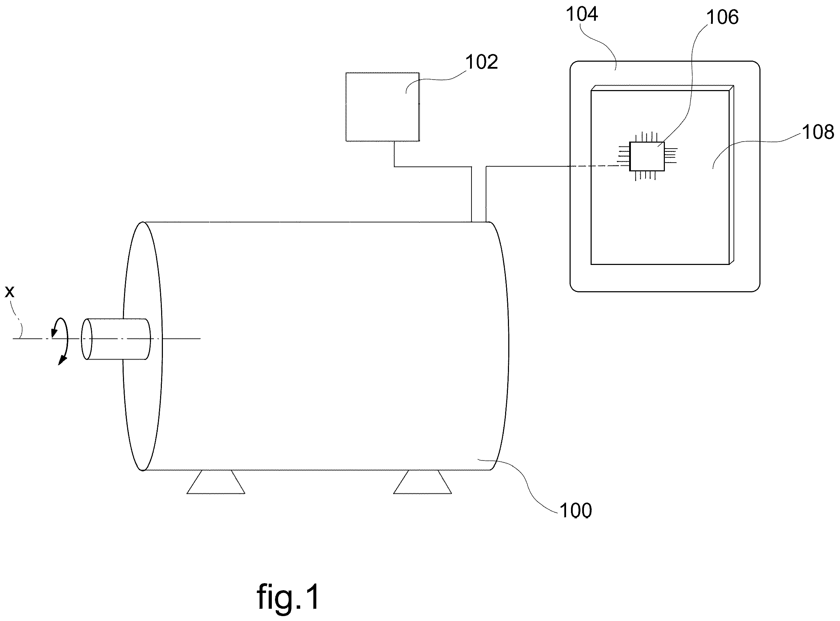

As may be observed in Figure 1, an electric motor 100 is an electric machine that converts electrical power supplied at the input into mechanical energy at the output on an axis x of the electric motor.

For example, the electrical power is supplied by an electrical power source 102.

The amount of mechanical energy supplied at the output is usually adjusted by means of electronic drive means 104.

For example, the electronic drive means 104 may be, or comprise, at least one of an electronic drive unit, an electronic drive controller 106, an electrical drive circuit 108, etc.

Should the electronic drive means 104 or the electric motor 100 fail, the amount of mechanical energy supplied at the output by the electric motor 100 may be zero or not correspond to an amount of mechanical energy expected in response to the electrical power supplied at the input and the control performed by the electronic drive means.

In the prior art, there are no known solutions for determining whether the failure occurred to the electric motor 100 or to the related electronic drive means 104.

Therefore, in the prior art, if it is found that the amount of mechanical energy supplied at the output by the electric motor 100 is zero or does not correspond to an expected amount of mechanical energy, the practice is to replace both the electric motor 100 and the related electronic drive means 104 .

### Summary of the invention

One object of the present invention is to provide a solution for monitoring electronic drive means that are arranged to be associated with an electric motor in order to determine the presence of any faults within the electronic drive means.

The present invention therefore makes it possible to determine whether a fault concerns the electric motor or the related electronic drive means.

Identification of an electronic drive means fault also makes it possible to avoid the replacement of the entire assembly comprising the electric motor and the related electronic drive means.

For example, it will be possible to evaluate whether the fault may be resolved by means of:
- replacing only the electric motor, when it is determined that the electronic drive means are not affected by a fault;
- replacing only the electronic drive means, when it is determined that such electronic drive means are affected by a fault;
- repairing the electronic drive means, when it is determined that such electronic drive means are affected by a fault.

The aforesaid and other objects and advantages are achieved, according to one aspect of the invention, by a system for testing electronic drive means for an electric motor having the features defined in claim 1 and, according to a further aspect of the invention, by a method for testing electronic drive means for an electric motor having the features defined in claim 8. Preferred embodiments of the invention are defined in the dependent claims, the content of which is to be understood as an integral part of the present description.

### Brief description of the drawings

The functional and structural features of some preferred embodiments of a system for testing electronic drive means for an electric motor and a method for testing electronic drive means for an electric motor according to the invention will now be described. Reference is made to the accompanying drawings, wherein:
- Figure 1 illustrates an exemplary electric motor and the related electronic drive means according to the prior art;
- Figure 2 is an exemplary block diagram relating to an embodiment of a system for testing electronic drive means for an electric motor according to this invention;
- Figure 3 shows two possible configurations that may be assumed by resistive loads;
- Figure 4 illustrates exemplary control means, display means and signaling means.

### Detailed description

Before explaining in detail a plurality of embodiments of the invention, it should be clarified that the invention is not limited in the application thereof to the design details and configuration of the components presented in the following description or shown in the drawings. The invention may assume other embodiments and be implemented or constructed in practice in different ways. It should also be understood that the phraseology and terminology have a descriptive purpose and should not be construed as limiting. The use of "include" and "comprise" and the variations thereof are intended to cover the elements set out below and the equivalents thereof, as well as additional elements and the equivalents thereof.

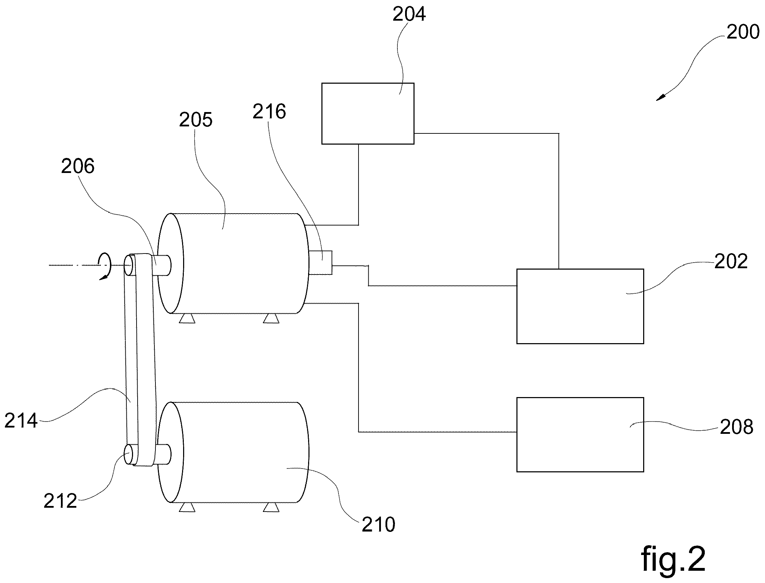

Referring initially to Figure 2, a first embodiment will be described of a system for testing electronic drive means for an electric motor.

Electronic drive means are also known in the art by the term the "driving" of an electric motor.

As may be seen in this Figure, the system 200 for testing electronic drive means for an electric motor comprises electronic control means 202 arranged for:
- being connected to electronic drive means 204 to be tested; and
- providing at least one test drive command to such electronic drive means 204 to be tested.

For example, the electronic drive means 204 may be or comprise at least one of an electronic drive unit, an electronic drive controller, an electrical drive circuit, etc.

The system 200 for testing electronic drive means for an electric motor further comprises a test electric motor 205 arranged to be connected to the electronic drive means 204 to be tested. The test electric motor 205 comprises a first rotor 206. One rotation of the first rotor 206 is arranged to be controlled by the electronic drive means 204 to be tested according to the value of the received test drive command.

In other words, by means of the test drive command, it is possible to adjust the rotational speed of the first rotor of the test electric motor and/or the rotational direction of the first rotor of the test electric motor.

For example, the electronic control means 202 may comprise or be associated with command means, such as a potentiometer, and the value of the test drive command may be set/adjusted by an operator using these command means.

For example, the test electric motor 205 may be an alternating current motor (AC motor), a direct current motor (DC motor), a brushless motor, or a stepper motor.

The system for testing electronic drive means for an electric motor further comprises an electrical energy supply means 208 arranged to provide electrical power to at least said test electric motor 205 and to said electronic drive means 204 to be tested. Preferably, the electrical energy supply means 208 may also power said electronic control means 202.

For example, the electrical energy supply means 208 may be or comprise a battery or means arranged to draw energy from a power line connected to a power supply network (for example, a building power line).

As may be seen again in Figure 2, the system 200 for testing electronic drive means for an electric motor further comprises a dragged electric motor 210 comprising a second rotor 212, and motion transmission means 214 arranged to transmit the rotation of the first rotor of the test electric motor to the second rotor of the dragged electric motor.

For example, the dragged electric motor 210 may also be an alternating current motor (AC motor), a direct current motor (DC motor), a brushless motor, or a stepper motor.

For example, the motion transmission means 214 arranged to transmit the rotation of the first rotor of the test electric motor to the second rotor of the dragged electric motor may be or comprise at least one of a belt, a chain, or the like.

In particular, because the second rotor of the dragged electric motor is connected to the first rotor of the test electric motor, the dragged electric motor may perform the function of a load connected to the first rotor of the test electric motor. Therefore, the presence of the dragged electric motor allows for the possibility of testing the drive control means when a load is present.

Additionally, the system 200 for testing electronic drive means for an electric motor comprises current sensor means 216 arranged to measure the current absorbed by the test electric motor, indicative of the operation of the electronic drive means 204 to be tested.

Preferably, the system for testing electronic drive means for an electric motor may further comprise display means 400 arranged to show the current absorbed by the test electric motor measured by the current sensor means 216.

The current sensor means 216 may, for example, comprise or be an amperometer.

The display means may, for example, be an analog display or a digital display.

By means of the display means, an operator in charge of performing the test will be able to monitor the trend of the absorbed current such as to be able to identify possible abnormal current trends that are indicative of the presence of a failure of the electronic drive means under test.

Preferably, the control means may be arranged to:
- during the provision of the test drive command to the electronic drive means, determine whether the absorbed current measured by the current sensor means corresponds to an expected absorbed current, the value of which is a function of the test drive command.

In other words, the electronic control means may also be tasked with verifying that the absorbed current measured by the current sensor means corresponds to an expected absorbed current. In other words, the expected absorbed current may be the current value that should be absorbed in response to the test actuation command, when the electronic drive means do not have a fault.

Preferably, when the electronic control means determine that the absorbed current measured by the current sensor means does not correspond to the expected absorbed current, the electronic control means may also be arranged to:
- generate a malfunction signal indicative of the fact that said electronic drive means are not operating correctly.

The malfunction signal may for example be transmitted to signaling means 401 of the system for testing electronic drive means for an electric motor or it may be transmitted to additional control means external to the system for testing electronic drive means for an electric motor.

The signaling means 401 may be visual signaling means, such as a light, a bulb, an LED, a display, or they may be acoustic signaling means, such as a siren.

The additional control means external to the system for testing electronic drive means for an electric motor may be or comprise, for example, control means of a computer of a unit designed to maintain the electric motor and the electronic drive means.

To transmit the malfunction signal to additional external control means, the system for testing electronic drive means for an electric motor may comprise communication means. The communication means may for example be cabled/wired solutions, or the communication means may be wireless solutions (e.g. Wi-Fi, Bluetooth, or the like).

Preferably, the electronic control means may be arranged to determine whether the absorbed current measured by the sensor means corresponds to an expected absorbed current, after a predetermined settling period has elapsed since the at least one test drive command has been provided to said electronic drive means.

In this way, it is possible to prevent any transient current values from being misinterpreted as malfunctions of the electronic drive means.

The system for testing electronic drive means for an electric motor may further comprise first resistive loads R1. Each first resistive load may be arranged to be connected to a pole of a respective winding of the dragged electric motor. The first resistive loads may be arranged to be connected to the poles of the windings of the dragged electric motor according to a first configuration.

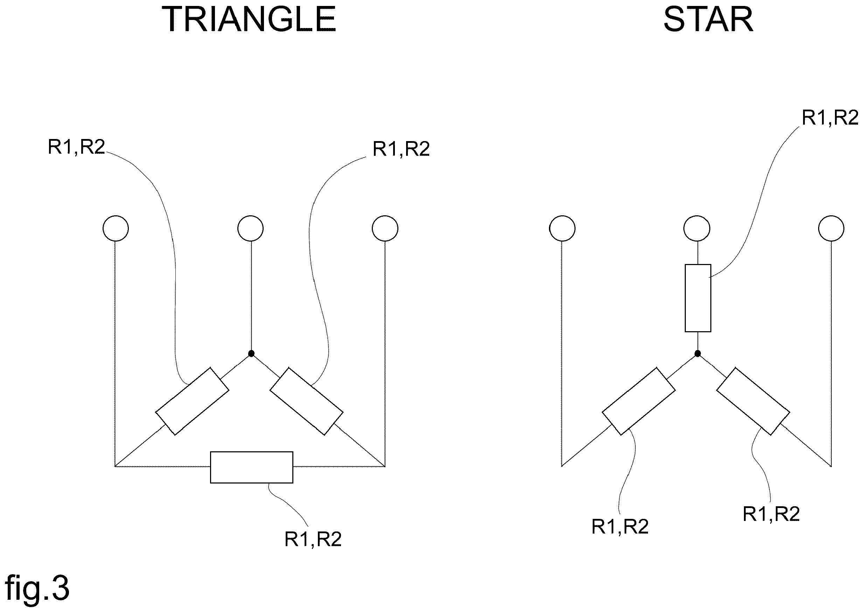

For example, as may be observed in Figure 3, the first configuration may be a triangle or star configuration.

Preferably, the system for testing electronic drive means for an electric motor may further comprise second resistive loads R2. Each second resistive load may be arranged to be connected to a pole of a respective winding of the dragged electric motor. The second resistive loads may be arranged to be connected to the poles of the windings of the dragged electric motor according to a second configuration that is different from said first configuration.

For example, as may be observed in Figure 3, the second configuration may be a triangle or star configuration.

In one example, if the first resistive loads are arranged in a triangle, the second resistive loads may be arranged in a star pattern.

Preferably, when both the first resistive loads and the second resistive loads are present, the electronic control means 202 may comprise or be associated with command means 402 and may be arranged for:
- connecting the first resistive loads to the poles of the windings of the dragged electric motor, when the command means 402 are brought into a first state by an operator;
- connecting the second resistive loads to the poles of the windings of the electric dragged motor, when the command means 402 are brought into a second state by an operator.

For example, the command means may be or comprise a two-state switch or a switch. Alternatively, when both the first resistive loads and the second resistive loads are present, the control means may comprise, or be associated with, first command means and second command means, and may be arranged for:
- connecting the first resistive loads to the poles of the windings of the dragged electric motor, when the first command means are brought by an operator from a first state to a second state;
- connecting the second resistive loads to the poles of the windings of the dragged electric motor, when the second command means are brought by an operator from a first state to a second state.

Preferably, the first command means and the second command means may not both assume the second state thereof simultaneously. In other words, the first command means may be brought to the second state thereof when the second command means are not in the second state thereof (i.e. they are in the first state thereof) and the second command means may be brought to the second state thereof when the first command means are not in the second state thereof (i.e. they are in the first state thereof).

For example, the first command means and the second command means may each comprise, or be, a switch, a button, a commutator, etc.

The possibility of varying the resistive loads connected to the poles of the windings of the dragged electric motor allows the value of the load generated by the dragged electric motor to be varied.

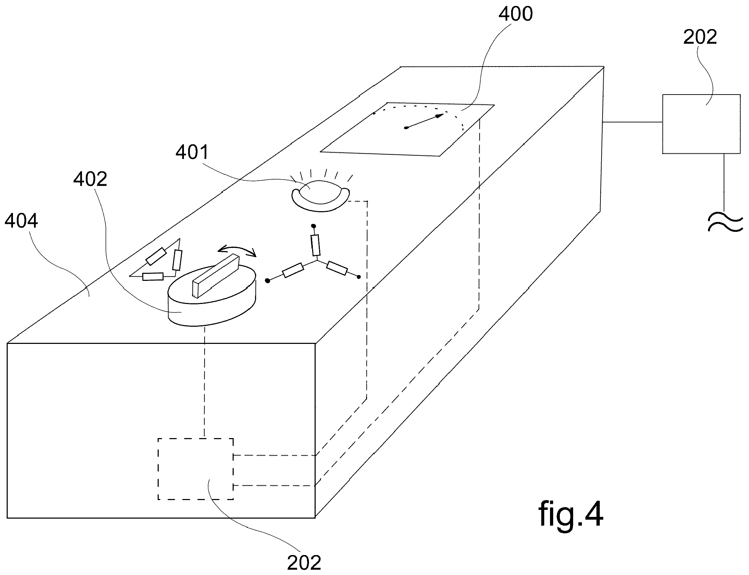

Exemplary command means, display means and signaling means are illustrated in Figure 4. As may be seen in this Figure, the command means, the display means, and the signaling means may be comprised in a control panel 404.

Furthermore, as may be observed in Figure 4, the electronic control means 202 may be comprised in the control panel or be connected to/associated with the control panel.

Preferably, all of the elements of the system for testing electronic drive means for an electric motor may be mounted on a single structure, for example such as to form a test bench.

The system for testing electronic drive means for an electric motor may further comprise additional command means associated with the electronic control means 202. By means of such additional command means an operator may be able to switch on and off the system for testing electronic drive means for an electric motor.

When the system for testing electronic drive means for an electric motor is switched off, the supply of electrical power to said test electric motor 205 and to said electronic drive means 204 to be tested by said electrical energy supply means 208, may be prevented.

In one example, the electronic control means 202 may be, or comprise, furthermore at least one processor, a microprocessor, a controller, a microcontroller, an FPGA, an PLC, or the like.

In a further aspect, the present invention relates to a method for testing electronic drive means for an electric motor, by means of a system for testing electronic drive means for an electric motor according to any one of the embodiments described above.

In one embodiment, the method comprises the steps of:
- via the electronic control means, providing at least one test drive command to said electronic drive means;
- via the electronic drive means to be tested, driving the electric test motor according to said test drive command, so as to generate a rotation of a first rotor of said test electric motor;
- by means of current sensor means, measuring the current drawn by the test electric motor indicative of the operation of the electronic drive means to be tested.

The method for testing electronic drive means for an electric motor may preferably also comprise the step of:
- showing the current absorbed by the test electric motor measured by the current sensor means on display means.

The method for testing electronic drive means for an electric motor may preferably also comprise the step of:
- while providing the test drive command to said electronic drive means, determining whether the absorbed current measured by the current sensor means corresponds to an expected absorbed current, the value of which is a function of said test drive command.

The method for testing electronic drive means for an electric motor may preferably also comprise the step of:
- when said electronic control means determine that the absorbed current measured by the current sensor means does not correspond to the expected absorbed current, generating a malfunction signal indicative of the fact that said electronic drive means are not operating correctly.

The advantages achieved are therefore that of having provided a solution that makes it possible to:
- monitor the electronic drive means arranged to be associated with an electric motor, in order to determine the presence of any faults within the electronic drive means;
- determine whether the fault concerns the electric motor or the related electronic drive means;
- identify the failure of the electronic drive means, so as to avoid the replacement of the entire assembly formed by the electric motor and the related electronic drive means;
- assess replacing the electric motor only when it is determined that the electronic drive means are not affected by a fault;
- assess replacing the electronic drive means only when it is determined that such electronic drive means are affected by a fault;
- assess repairing the electronic drive means, when it is determined that such electronic drive means are affected by a fault.

Various aspects and embodiments of a system for testing electronic drive means for an electric motor and of a method for testing electronic drive means for an electric motor according to the invention have been described. It is understood that each embodiment may be combined with any other embodiment. Moreover, the invention is not limited to the embodiments described, but may be varied within the scope defined by the appended claims.

## Claims

1. System (200) for testing electronic drive means for an electric motor, comprising:
- electronic control means (202) arranged to be connected to said electronic drive means (204) to be tested and to provide at least one test drive command to said electronic drive means (204);
- a test electric motor (205) arranged to be connected to said electronic drive means (204) to be tested and comprising a first rotor (206), wherein a rotation of said first rotor (206) is arranged to be controlled by said electronic drive means (204) to be tested according to the value of the received test drive command;
- electrical power supply means (208) arranged to provide electrical power to said test electric motor (205) and to said electronic drive means (204) to be tested;
- a dragged electric motor (210) comprising a second rotor (212);
- motion transmission means (214) arranged to transmit the rotation of the first rotor (206) of the test electric motor (205) to the second rotor (212) of the dragged electric motor (210);
- current sensor means (216) arranged to measure a current absorbed by the test electric motor (205) indicative of the operation of said electronic drive means (204) to be tested.

2. System (200) for testing electronic drive means for an electric motor according to claim 1, further comprising display means (400) arranged to show said current absorbed by the test electric motor (205) measured by the current sensor means (216).

3. System (200) for testing electronic drive means for an electric motor according to claims 1 or 2, wherein said electronic control means (202) are further arranged to:
- during the provision of the test drive command to said electronic drive means (204), determine whether the absorbed current measured by said current sensor means (216) corresponds to an expected absorbed current, the value of which is a function of said test drive command.

4. System (200) for testing electronic drive means for an electric motor according to claim 3, wherein, when said electronic control means (202) determine that the absorbed current measured by the current sensor means (216) does not correspond to the expected absorbed current, said electronic control means (202) are arranged to:
- generate a malfunction signal indicative of the fact that said electronic control means (204) are not operating correctly.

5. System (200) for testing electronic drive means for an electric motor according to claim 3 or 4, wherein said electronic control means (202) are arranged to determine whether the absorbed current measured by the current sensor means (216) corresponds to the expected absorbed current, after a predetermined settling period has elapsed since the at least one test drive command has been provided to said electronic drive means (204).

6. System (200) for testing electronic drive means for an electric motor according to any one of the preceding claims, comprising first resistive loads (R1);
wherein, each first resistive load is arranged to be connected to a pole of a respective winding of the dragged electric motor (210);
said first resistive loads (R1) being arranged to be connected to the poles of the windings of the electric dragged motor (210) according to a first configuration.

7. System (200) for testing electronic drive means for an electric motor according to claim 6, comprising second resistive loads (R2);
wherein, each second resistive load is arranged to be connected to a pole of a respective winding of the dragged electric motor (210);
said second resistive loads (R2) being arranged to be connected to the poles of the windings of said electric dragged motor (210) according to a second configuration that is different from said first configuration;
wherein said electronic control means (202) comprise or are associated with command means (402) and are arranged for:
- connecting said first resistive loads (R1) to the poles of the windings of the dragged electric motor (210), when said command means are brought to a first state by an operator;
- connecting said second resistive loads (R2) to the poles of the windings of said dragged electric motor (210), when said command means are brought to a second state by an operator;
or,
wherein said control means comprise or are associated with first command means and second command means, and are arranged for:
- connecting said first resistive loads (R1) to the poles of the windings of the electric dragged motor (210), when said first command means are brought by an operator from a first state to a second state;
- connecting said second resistive loads (R2) to the poles of the windings of the dragged electric motor (210), when said second command means are brought by an operator from a first state to a second state;
wherein the first command means and the second command means are configured so that they cannot both assume the second state thereof simultaneously.

8. Method for testing electronic drive means for an electric motor by means of a system (200) for testing electronic drive means for an electric motor according to any one of the preceding claims;
the method comprising the steps of:
- via the electronic control means (202), providing at least one test drive command to said electronic drive means (204) to be tested;
- via the electronic drive means (204) to be tested, driving said test electric motor (205) according to said test drive command, so as to generate a rotation of a first rotor (206) of said test electric motor (205);
- by means of current sensor means (216), measuring the current drawn by said test electric motor (205) indicative of the operation of said electronic drive means to be tested.

9. Method for testing electronic means for driving an electric motor according to claim 8, further comprising the step of:
- displaying the current absorbed by the test electric motor (205) measured by current sensor means (216) on display means.

10. Method for testing electronic drive means for an electric motor according to claim 8 or 9, further comprising the step of:
- while providing the test drive command to said electronic drive means (204) to be tested, determining whether the absorbed current measured by the current sensor means (216) corresponds to an expected absorbed current, the value of which is a function of said test drive command.

11. Method for testing electronic driving means of an electric motor according to claim 10, further comprising the step of:
- when said electronic control means (202) determine that the absorbed current measured by said current sensing means (216) does not correspond to the expected absorbed current, generating a malfunction signal indicative of the fact that said electronic control means (204) are not operating correctly.
